# EUROPEAN PATENT APPLICATION

(11) **EP 3 327 467 A1**
(43) Date of publication of application: **30.05.2018**
(21) Application number: 15890196.7
(22) Date of filing: 31.12.2015
(51) Int. Cl.: G01V 1/18

(54) **COUPLING MEASUREMENT DETECTOR**

(30) Priority: 27.04.2015 CN 201520258826 U
(71) Applicant: Wei, Jidong, Qingdao, Shandong 266071 (CN); Shengli Oil Field Xinsheng Ptroleum Geophysical Technology Service CO,. LTD, Niuzhuang Town Dongying City Shandong 257086 (CN)
(72) Inventor: WEI, Jidong, Qingdao, Shandong 266071 (CN)
(74) Representative: Vitina, Maruta
(86) International application number: PCT/CN2015/000944
(87) International publication number: WO 2016/172816

(57) **Abstract**

A coupling measurement detector. The coupling measurement detector comprises piezoelectric ceramic crystals (1, 2, 3), a detector (4) and a corresponding power supply circuit. The three piezoelectric ceramic crystals (1, 2, 3) are respectively located at the top of the detector (4) and on two mutually perpendicular side faces. By processing data measured by the coupling measurement detector, a detector-earth coupling response corresponding to a buried point of the detector can be obtained, and then the influence of the coupling response on seismic data can be eliminated through calculation, thereby improving the fidelity, signal-to-noise ratio and resolution of ground vibration data picked up by the coupling measurement detector.

## Description

### TECHNICAL FIELD

The present utility model relates to a field of sensor-ground coupling effect measurement by sensor itself, and specifically to a coupling evaluation sensor.

### BACKGROUND

In theory, a ground-sensor coupling system is a Linear Time-Invariant System. If a mechanical impulse is imposed as an input and the corresponding output is measured, the output could be regarded as the impulse response of the system. However, a mechanical impulse excitation is a transient excitation which should be constantly stable in a frequency range of -∞ ∼ +∞ but never exists in reality. Some equipment such as shaking table, exciter, vibration machine and exciting hammer is utilized usually for approximation in a certain frequency band range. However, the equipment mentioned above cannot fulfill a requirement of modeling a mechanical impulse in a seismic exploration. Thus, a novel coupling evaluation sensor is invented to generate a qualified mechanical impulse imposed to a sensor and evaluate the parameters of sensor-ground coupling effect accordingly.

### SUMMARY

The present utility model is to provide a sensor which is able to evaluate the impulse response of sensor-ground coupling effect.

Technical solutions to achieve an objective of the present utility model are as follows.

A coupling evaluation sensor comprises a first piezoelectric ceramic crystal and a sensor. The first piezoelectric ceramic crystal is provided at a top end of the sensor.

The objective of the present utility model can also be achieved by following technical solutions.

The coupling evaluation sensor also comprises a second piezoelectric ceramic crystal and a third piezoelectric ceramic crystal. The second piezoelectric ceramic crystal is provided at a first lateral side of the sensor. The third piezoelectric ceramic crystal is provided at a second lateral side of the sensor perpendicular to the first lateral side of the sensor.

The first piezoelectric ceramic crystal is provided at the center of the top end inside a housing of the coupling evaluation sensor. The second piezoelectric ceramic crystal and the third piezoelectric ceramic crystal are respectively provided at the centers of the first lateral side and the second lateral inside the housing of the coupling evaluation sensor. The second piezoelectric ceramic crystal and the third piezoelectric ceramic crystal are adhered on the housing of the coupling evaluation sensor by an industrial glue.

The first piezoelectric ceramic crystal, the second piezoelectric ceramic crystal and the third piezoelectric ceramic crystal are made of piezoelectric materials comprising barium titanate BT, lead zirconate titanate PZT and modified lead zirconate titanate.

The first piezoelectric ceramic crystal, the second piezoelectric ceramic crystal and the third piezoelectric ceramic crystal has a round shape or a square shape.

A size parameter and a weight parameter of the first piezoelectric ceramic crystal, the second piezoelectric ceramic crystal or the third piezoelectric ceramic crystal are specific parameters determined by experiment, under a basis of enabling an output signal to be stronger than an ambient noise.

A thickness of the first piezoelectric ceramic crystal, the second piezoelectric ceramic crystal or the third piezoelectric ceramic crystal is determined based on a type of the first piezoelectric ceramic crystal, the second piezoelectric ceramic crystal and the third piezoelectric ceramic crystal; the thickness enables an output vibration signal to be stronger than the ambient noise and maintains a distance of at least 2mm to an inner core of the coupling evaluation sensor.

The coupling evaluation sensor includes a piezoelectric crystal combined with a moving-coiled modeling geophone, or a digital sensor, or a piezoelectric sensor or an eddy sensor and the like.

The coupling evaluation sensor in the present utility model, is able to obtain an impulse response to the ground-sensor coupling system, by processing an output signal from the sensor excited by a mechanical impulse. A theory of single-degree-of-freedom system in vibration mechanics, and related technology and methods for processing and analysis such as processing and analysis on digital signal, signal and system, as well as analysis on seismic data characteristics are applied in the present utility model. The sensor-ground coupling effect on seismic data can be eliminated by calculation afterwards. The fidelity, Signal/Noise ratio and resolution of data of the coupling evaluation sensor could be improved.

### BRIEF DESCRIPTION OF DRAWINGS

Fig. 1 shows a front view of the coupling evaluation sensor in the embodiment of the present utility model.
Fig. 2 shows a left view of the coupling evaluation sensor in the embodiment of the present utility model.
Fig. 3 shows a top view of the coupling evaluation sensor in the embodiment of the present utility model.

### DETAILED DESCRIPTION

Preferred embodiments are given below with drawings for understanding the objective and characteristics of the present utility model.

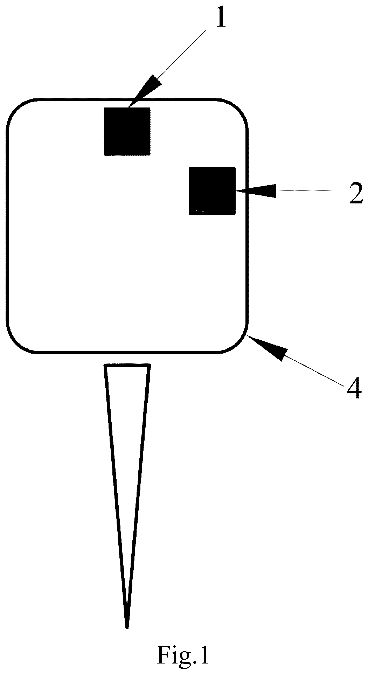

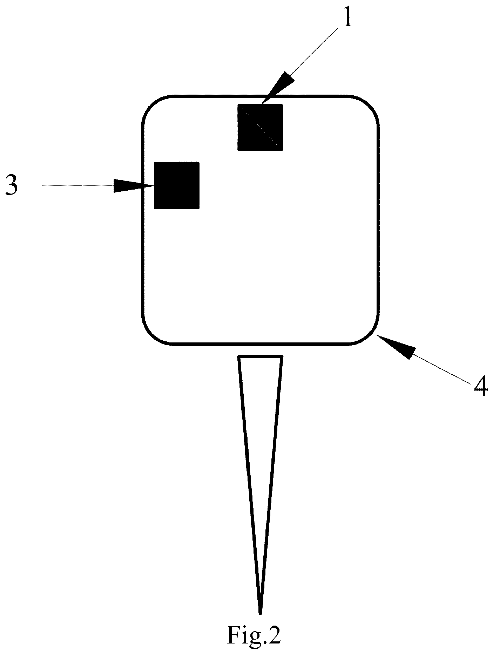

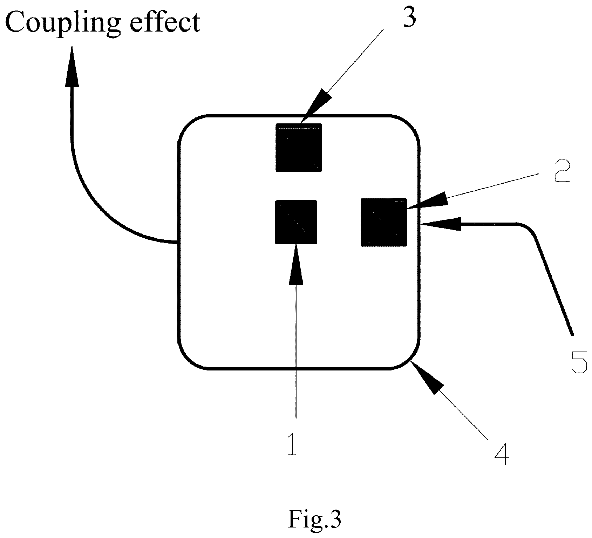

As shown in Fig.1, Fig. 2 and Fig. 3, the coupling evaluation sensor comprises a first piezoelectric ceramic crystal 1, a second piezoelectric ceramic crystal 2, a third piezoelectric ceramic crystal 3 and a sensor 4. The first piezoelectric ceramic crystal 1 is provided at the top of the sensor 4. The second piezoelectric ceramic crystal 2 is provided at the first lateral side of the sensor 4. The third piezoelectric ceramic crystal 3 is provided at the second lateral side of the sensor 4 perpendicular to the first lateral side of the sensor.

In the embodiment, the first piezoelectric ceramic crystal 1, the second piezoelectric ceramic crystal 2 and the third piezoelectric ceramic crystal 3 are provided inside the housing of the coupling evaluation sensor (top and two lateral sides). These three piezoelectric ceramic crystals 1, 2, and 3 are adhered tightly on the housing of the coupling evaluation sensor by an industrial glue.

In the embodiment, the first piezoelectric ceramic crystal 1, the second piezoelectric ceramic crystal 2 and the third piezoelectric ceramic crystal 3 are made of piezoelectric materials comprising barium titanate BT, lead zirconate titanate PZT and modified lead zirconate titanate.

The first piezoelectric ceramic crystal 1, the second piezoelectric ceramic crystal 2 and the third piezoelectric ceramic crystal 3 has a round shape or a square shape. The smaller of the weight and the size of the piezoelectric ceramic crystals 1, 2, and 3, the better they will be. In the embodiment, the size and the weight of the first piezoelectric ceramic crystal 1, the second piezoelectric ceramic crystal 2 or the third piezoelectric ceramic crystal 3 enable the output signal to be stronger than the ambient noise. Therefore, specific parameters should be determined by experiments according to different materials.

In the embodiment, thickness of the first piezoelectric ceramic crystal, the second piezoelectric ceramic crystal and the third piezoelectric ceramic crystal are determined according to a kind of the piezoelectric ceramic crystal and mode of combination. In general, the output vibration signal should be stronger than the ambient noise and the piezoelectric ceramic crystals should maintain a distance of at least 2mm to an inner core of the coupling evaluation sensor.

In the embodiment, the coupling evaluation sensor includes a piezoelectric crystal combined with a moving-coiled geophone, a MEMS digital sensor, a piezoelectric sensor or an eddy sensor.

The square-wave generator 5 provides power to the piezoelectric ceramic crystals during an operation of the coupling evaluation sensor of the present utility model. The output signal from sensor 4 after processing could be deemed as the sensor-ground coupling effect. If the sensor 4 only has vertical component, only the first piezoelectric ceramic crystal provided on the top of is needed.

The present utility model provides a sensor with an ability of automatically measuring a sensor-ground coupling effect, which is short for "Coupling Evaluation sensor (CEG)". The coupling evaluation sensor comprises a plurality of piezoelectric ceramic crystals, a sensor and a relevant supplying circuit. Three piezoelectric ceramic crystals are respectively provided on the top and two lateral sides of the sensor. By processing measurement data derived from the coupling evaluation measurement a sensor-ground coupling effect is obtained at a corresponding embedment point of the coupling evaluation sensor. The effect of sensor-ground coupling on the seismic data can be eliminated by calculation. The fidelity, Signal/Noise ratio and resolution of data of the coupling evaluation sensor could be improved.

## Claims

1. A coupling evaluation sensor, comprising:
a first piezoelectric ceramic crystal and a sensor; wherein the first piezoelectric ceramic crystal is provided at a top of the sensor.

2. The coupling evaluation sensor according to claim 1, wherein the coupling evaluation sensor further comprises a second piezoelectric ceramic crystal and a third piezoelectric ceramic crystal; the second piezoelectric ceramic crystal is provided at a first lateral side of the sensor; and the third piezoelectric ceramic crystal is provided at a second lateral side of the sensor perpendicular to the first lateral side of the sensor.

3. The coupling evaluation sensor according to claim 2, wherein the first piezoelectric ceramic crystal is provided at the center of the top inside a housing of the coupling evaluation sensor;
the second piezoelectric ceramic crystal and the third piezoelectric ceramic crystal are respectively provided at the centers of the first lateral side and the second lateral side inside the housing of the coupling evaluation sensor; and
the second piezoelectric ceramic crystal and the third piezoelectric ceramic crystal are adhered on the housing of the coupling evaluation sensor by an industrial glue.

4. The coupling evaluation sensor according to claim 2, wherein the first piezoelectric ceramic crystal, the second piezoelectric ceramic crystal and the third piezoelectric ceramic crystal are made of piezoelectric materials comprising barium titanate BT, lead zirconate titanate PZT and modified lead zirconate titanate.

5. The coupling evaluation sensor according to claim 2, wherein the first piezoelectric ceramic crystal, the second piezoelectric ceramic crystal and the third piezoelectric ceramic crystal have a circular or square shape.

6. The coupling evaluation sensor according to claim 2, wherein a size parameter and a weight parameter of the first piezoelectric ceramic crystal, the second piezoelectric ceramic crystal or the third piezoelectric ceramic crystal are specific parameters determined by an experiment, under a basis of enabling an output signal to be stronger than an ambient noise.

7. The coupling evaluation sensor according to claim 2, wherein a thickness of the first piezoelectric ceramic crystal, the second piezoelectric ceramic crystal or the third piezoelectric ceramic crystal is determined based on a type of the first piezoelectric ceramic crystal, the second piezoelectric ceramic crystal and the third piezoelectric ceramic crystal; the thickness enables an output vibration signal to be stronger than the ambient noise and maintains a distance of at least 2mm to an inner core of the coupling evaluation sensor.

8. The coupling evaluation sensor according to claim 1, wherein the coupling evaluation sensor includes a piezoelectric crystal combined with a moving-coiled geophone, or a Micro-Electro-Mechanical System (MEMS) digital sensor, or a piezoelectric sensor or an eddy sensor.
